# EUROPEAN PATENT APPLICATION

(11) **EP 4 309 835 A1**
(43) Date of publication of application: **24.01.2024**
(21) Application number: 22771303.9
(22) Date of filing: 11.03.2022
(51) Int. Cl.: B23B 27/14, C23C 14/06

(54) **SURFACE-COATED CUTTING TOOL**

(30) Priority: 19.03.2021 JP 2021046163
(71) Applicant: Mitsubishi Materials Corporation, Tokyo 100-8117 (JP)
(72) Inventor: EBATA, Tomoki, Tokyo 100-8117 (JP); ASANUMA, Hidetoshi, Tokyo 100-8117 (JP)
(74) Representative: Gille Hrabal Partnerschaftsgesellschaft mbB Patentanwälte
(86) International application number: PCT/JP2022/010850
(87) International publication number: WO 2022/196555

(57) **Abstract**

A coating layer including first sublayers and second sublayers alternately deposited. The first sublayers each has an average thickness in a range of 0.5 nm to 100.0 nm and has an average composition represented by (AlₓTi_{1-x-y-z}M_{y})B_{z}N (M is at least one element selected from the group consisting of groups 4, 5, and 6 elements and lanthanoid elements in the periodic table, 0.100 ≤ x≤0.640, 0.001≤y≤0.100, 0.060≤z≤0.400). The second sublayers each has an average thickness in a range of 0.5 nm to 100.0 nm and has an average composition represented by (AlₚCr₁₋ₚ)N ( 0.650≤p≤ 0.900). The coating layer includes a cutting edge ridge and a flank and has a B content, the B content at the cutting edge being at least 60% of the B content in an area at least 1 mm away from the cutting edge ridge toward the flank.

## Description

### Technical Field

The present invention relates to a surface-coated cutting tool (hereinafter, referred to as coated tool). This application claims the priority benefit of Japanese Patent Application No. 2021-46163 filed on March 19, 2021. The entire contents described in the Japanese patent application are thereby incorporated by reference herein.

### Background Art

Coated tools have been known for some time. For example, such a coating tool includes a tool substrate composed of a tungsten carbide (hereinafter denoted by WC) based cemented carbide covered with a coating layer. Proposals for achieving coating layers with higher hardness also have been proposed through adjustment of the compositions of the coating layers.

For example, PTL 1 discloses a coated tool including a coating layer having an average thickness in the range of 0.5 to 8.0 µm and including a boron nitride layer indicated by the formula: (AlₓTi₁₋ₓ)(B_{y}N_{1-y}) (where x: 0.05 to 0.75, y: 0.02 to 0.12) on the surface of a substrate. The coating tool includes a coating layer containing boron (B), i.e., a boron nitride layer that exhibits high wear resistance and low reactivity (low adhesion) with iron-based work material (low deposition of melt).

### Citation List

### Patent Literature

[PTL 1] Japanese Unexamined Patent Publication No. H4-26756

### Summary of Invention

### Technical Problem

An object of the present invention, which has been accomplished in view of the aforementioned circumstances and proposal, is to provide a coated tool that exhibits high wear resistance even while the tool is subjected to high-speed cutting at least 30% higher than normal conditions of martensite stainless steel, for example.

### Solution to Problem

A surface coated cutting tool in accordance with an embodiment of the present invention comprises a substrate and coating layer on the substrate; wherein
2) the coating layer has an average thickness in a range of 0.1 µm to 10.0 µm, the coating layer including first sublayers and second sublayers alternately deposited;
3) the first sublayers each has an average thickness in a range of 0.5 nm to 100.0 nm and has an average composition represented by the formula (AlxTi1-x-y-zMy)BzN (where M is at least one element selected from the group consisting of groups 4, 5, and 6 elements and lanthanoid elements in the periodic table, x is in a range of 0.100 to 0.640, y is in a range of 0.001 to 0.100, and z is in a range of 0.060 to 0.400);
4) the second sublayers each has an average thickness in a range of 0.5 nm to 100.0 nm and has an average composition represented by the formula: (AlpCr1-p)N (where p is in a range of 0.650 to 0.900); and
5) the coating layer includes a cutting edge ridge and a flank and has a B content, the B content at the cutting edge being at least 60% of the B content in an area at least 1 mm away from the cutting edge ridge toward the flank. Advantageous Effects of Invention

The embodiment of the surface coated cutting tool exhibits high wear resistance and high fracture resistance even while the tool is subjected to high-speed cutting of stainless steels, such as martensitic stainless steel.

### Brief Description of Drawings

Fig. 1 is a schematic diagram of a longitudinal section of an exemplary coating layer in a surface coated cutting tool in accordance with an embodiment of the present invention.
Fig. 2 is a schematic diagram illustrating a cutting edge ridge in a surface coated cutting tool in accordance with an embodiment of the present invention. Description of Embodiments

The inventor has made an extensive study of coated tools that exhibit high wear resistance even while used for high-speed cutting of stainless steels such as martensitic stainless steel. As a result, the inventor has concluded that mere coating of a B-containing coating layer would not support both wear resistance and chipping resistance at the same time because the B-containing coated layer is brittle regardless of high wear resistance.

The inventor has inferred, in consideration of the principle of ion plating, that the content of B, which is a light element, at the cutting edge ridge is lower than that in areas away from the cutting edge ridge due to resputtering and that the improvement in hardness by B content is not fully demonstrated. In conclusion, since the hardness differs between the cutting edge ridge and other areas, wear does not propagate uniformly and abnormal damage such as chipping may occur.

Based on these concepts, the inventor has further investigated to find the following finding: A B-free sublayer provided in the coating layer can compensate for the brittleness of the B-containing layer and to suppress the occurrence of abnormal damage in the coating layer, whereas a suppressed decrease in B content at the cutting edge ridge can improve the high temperature hardness and thus lead to high wear resistance of the coating layer.

The coated tool in accordance with an embodiment of the present invention will now be described in more detail. In this specification and claims, a range of a numerical value represented by "A to B" is synonymous with "A or more and B or less", and the numerical range includes the upper limit (B) and lower limit (A). In the case that the unit is stated only for the upper limit (B), the upper limit (B) and lower limit (A) have the same unit.

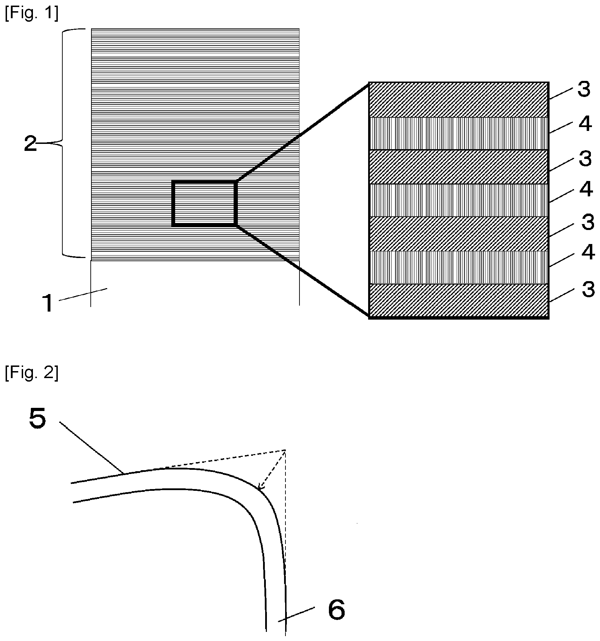

The layer structure of the coating layer of the coated tool in accordance with the embodiment of the present invention is schematically shown in Fig. 1.

### 1. Coating layer

The coating layer will now be described.

### (1) Average thickness

In the coated tool of this embodiment, the coating layer, including the alternately deposited first sublayers and second sublayers, should preferably has an average thickness in the range of 0.1 µm to 10.0 µm for the following reasons: An average thickness of less than 0.1 µm fails to achieve high wear resistance over a long period of use. An average thickness exceeding 10.0 µm often forms coarse crystal grains in the coating layer to impair the chipping resistance. In more preferred embodiment, the average thickness ranges from 0.8 µm to 8.0 µm.

### (2) Structure of coating layer

As illustrated schematically in Figure 1, the coating layer (2) in the coated tool of this embodiment is provided on the substrate (1) and includes first sublayer (3) and second sublayer (4) that are alternately deposited.

### (2-1) First sublayer

It is preferred that the first sublayers each should have an average thickness in the range of 0.5 nm to 100.0 nm and should have an average composition over all the first sublayers should be represented by the formula: (AlₓTi_{1-x-y-z}M_{y})B_{z}N (where M is at least one element selected from the group consisting of groups 4, 5, and 6 elements and lanthanoid elements in the periodic table, x is in the range of 0.100 to 0.640, y is in the range of 0.001 to 0.100, and z is in the range of 0.060 to 0.400. It is noted that the B content z may locally deviate from the above range as long as the first layers as a whole meets the above range.

The groups 4, 5, and 6 elements are Zr, Hf, V, Nb, Ta, Cr, Mo, and W

The reason why the average thickness of the above range is preferred is as follows: A thickness of less than 0.5 nm fails to an improvement in crack propagation resistance to be achieved by the alternately deposited structure, whereas a thickness exceeding 100.0 nm fails to an improvement in wear resistance to be achieved by the alternate deposition in nanoscale.

The reasons why the average composition of the above range are as follows:
An x value of less than 0.100 leads to an insufficient improvement in heat resistance of the first sublayer to be expected by the addition of Al. An x value exceeding 0.640 leads to decreased hardness of the first sublayer and insufficient wear resistance.

A y value of less than 0.001 leads to insufficient improvements in heat resistance and mechanical characteristics of the first sublayers to be expected by the addition of M. Ay value exceeding 0.100 leads to a decrease in toughness of the first layer and ready chipping and defects.

A z value of less than 0.060 leads to an insufficient improvement in the hardness of the first layer to be expected by the addition of B. A z value of greater than 0.040 leads to a decrease in toughness of the first layer and ready chipping and defects.

### (2-2) Second sublayer

It is preferred that the second sublayers each should have an average thickness in the range of 0.5 nm to 100.0 nm and should have an average composition over all the first sublayers should be represented by the formula: (AlₚCr₁₋ₚ)N (where p is in the range of 0.650 to 0.900).

The reason why the average thickness of the above range is preferred is as follows: A thickness of less than 0.5 nm leads to an insufficient improvement in crack propagation resistance brought about by the layered structure, whereas a thickness exceeding 100.0 nm leads to an insufficient improvement in wear resistance brought about by the nano-sublayer structure.

The reasons why the average composition of the above range are as follows:
A p value of less than 0.650 leads to an insufficient improvement in heat resistance of the second layer to be expected by the addition of Al. A p value exceeding 0.900 leads to decreased hardness and insufficient wear resistance of the second layer.

### (2-3) Alternate deposition of first sublayers and second sublayers

The first and second sublayers should preferably be alternately deposited across the thickness. In such alternate deposition, the brittleness of the first sublayer, which has increased wear resistance due to an increased B content, is offset by the second sublayer, which contains no B. As a whole, the coating layer provides excellent wear and chipping resistance even use in high-speed cutting of stainless steels such as martensite stainless steels.

It is noted that the sublayer closest to the substrate and/or the sublayer closest to the tool substrate surface may be either the first or second sublayer, under the condition that the first and second sublayers are alternately deposited.

Any numbers of first and second sublayers may be deposited as long as the first and second sublayers each satisfy the average thicknesses in the aforementioned ranges and the average thickness of the coating layer also satisfies the average thicknesses in the aforementioned ranges. In more preferred embodiments, however, the total number of sublayers (sum of the number of first sublayers and the number of second sublayers) is in the range of 50 to 1000 to ensure the aforementioned objectives.

### (2-4) B content at cutting edge ridge

The B content at the cutting edge ridge of the coating layer should preferably be at least 60% of the B content in the area at least 1 mm away from the cutting edge ridge of the coating layer toward the flank surface. Although the B content has no upper limit, the upper limit can reach 100% in production by the PVD process described below.

The B content reaches a substantially constant value at a distance exceeding 1 mm from the cutting edge ridge to the flank surface. In the examples described below, the B content is measured at a point on a line 1.5 mm away from the cutting edge ridge toward the flank surface.

"The B content reaches a substantially constant value" indicates that the average value of B contents at any five arbitrary points on any line segment that is parallel to and is at least 1 mm away from the cutting edge ridge toward the flank surface is substantially the same value within the margin of error.

An example that the B content at the cutting edge ridge of the coating layer is at least 60% of the B content in the area at least 1 mm away from the cutting edge ridge of the coating layer toward the flank surface is as follows: At a B content of 15 atomic% (z=0.15) in the area at least 1 mm away toward the flank surface, the B content at the cutting edge ridge is at least 9 (= 0.15×60/100) atomic%.

This prevents a decrease in B content at the cutting edge ridge, and the coating layer has improved high-temperature hardness and high wear resistance.

As shown in Fig. 2, when the rake face (5) and the flank face (6) are approximated by straight lines, the cutting edge ridge is a point closest to the intersection of the approximate straight lines (indicated by the dotted arrow) on the surface of the coating layer, in the region connecting the points where the straight lines separated from the rake face and the flank face. (that is, the region from the inflection point of the rake face to the inflection point of the flank face on the surface of the coating layer)

### (3) Other layer

The purpose of the present invention can be achieved by deposition of the first and second sublayers. A TiN layer may also be formed on the coating layer. Since the TiN layer itself has a golden color tone (the TiN layer may have any non-stoichiometric composition that exhibits golden color tone), this layer can function as an identification layer to determine the state of use (mint or used) of the cutting tool through a change in color tone.

The TiN identification layer may have an average thickness in the range of, for example, 0.1 µm to 1.0 µm.

### (4) Unintended layer

In the embodiment described above, no layers other than the first sublayers, second sublayer, and the upper layer (TiN layer) are deposited. When the layer to be deposited is switched (from one layer to another adjacent layer), unintended pressure fluctuations may occur in the deposition system, and unintended layers that contain oxygen and carbon and thus have different compositions may form between two adjacent layers.

The average thickness of each layer in the embodiment is determined with an energy dispersive X-ray spectrometer (EDS) attached to a scanning electron microscope (SEM) or transmission electron microscope (TEM). The cross section across the thickness of the layer (the longitudinal cross section perpendicular to the horizontal plane) is observed where the surface of the substrate is regarded as a horizontal plane and minute irregularities on the substrate surface are ignored. The thickness is measured at several points (for example, five points) of an image observed at a magnification of 5000 and averaged.

The average composition is determined as follows: A longitudinal section is observed by TEM-energy dispersive X-ray spectroscopy (EDS) to analyze multiple lines (e.g., five lines) across the thickness to determine the average values of the Al, Ti, Cr, and M contents. In order to determine the B content z, the Al, Ti, Cr, M, and B contents of the entire coating layer are determined from the surface with an electron probe micro analyzer (EPMA). Since the second sublayer does not contain B, the ratio of the Ti content to the B content in the first sublayer equals the ratio of the Ti content to the B content in the entire coating layer. Accordingly, the B content of the first sublayer is determined from the Ti and M contents determined by TEM-EDS and the Ti, M, and B contents determined by EPMA.

### 2. Substrate

### (1) Material

The substrates used in this embodiment may be any conventionally known substrate materials, with proviso that they contribute to the achievement of the aforementioned purpose. Preferred examples include cemented carbides (WC-based cemented carbides, those containing Co in addition to WC, and also those containing carbides of Ti, Ta, and Nb), cermets (TiC, TiN, and TiCN as main components), ceramics (titanium carbide, silicon carbide, silicon nitride, aluminum nitride, and aluminum oxide), and cBN sintered compacts, and diamond sintered compacts.

### (2) Shape

The substrate may have any shape that can be used as a cutting tool, for examples, the shape of an insert and the shape of a drill.

### 3. Production

The coating layer of the coated tool of the present invention can be produced in a deposition system with an arc ion plating (AIP) deposition source, which is a type of PVD. The first sublayers are deposited with an AlTiMB target (where M is at least one element selected from the group consisting of groups 4, 5, and 6 elements, and lanthanoid elements in the periodic table) while the second sublayers are deposited with an AlCr target. The first and second sublayers are alternately deposited by arc discharge. The B content of the cutting edge ridge can be controlled to at least 60% of the B content in a region at least 1 mm away from the cutting edge ridge toward the flank surface though adjustment of the bias voltage and arc current.

### Examples

Examples will now be described.

In examples of the coated tool of the present invention, WC-based cemented carbide substrates are applied to insert cutting tools. The substrates may also be made of any of the aforementioned materials. The cutting tools may also be drills or end mills.

Co, TiC, VC, TaC, NbC, Cr₃C₂, and WC raw material powders were prepared. These raw material powders were blended in accordance with formulations shown in Table 1, and then wax was added. The mixtures were wet-mixed for 72 hours in a ball mill, was dried under reduced pressure, and was compacted under a pressure of 100 MPa. These compacts were sintered and machined into specified dimensions to produce WC-based cemented carbide substrates 1 to 3 each having the shape of an insert in accordance with the ISO standard SEEN1203AFTN1.

In order to form a coating layer on each of substrates 1 to 3 in a deposition system equipped with AIP evaporation sources, each substrates was ultrasonically cleaned in acetone, was dried, and then was mounted along the periphery at a predetermined radial distance from the central axis on the turn table in the system. AlTiMB (M was as shown in Table 3) and AlCr targets were placed as cathodes (evaporation sources).

While the interior of the deposition system was evacuated to a vacuum of less than 10⁻² Pa, the interior of the system was heated to 400°C by a heater, the vacuum atmosphere was replaced with an Ar gas atmosphere of 1.0 Pa, and then a DC bias voltage of -1000 V was applied to the substrate revolving on the turn table. The surface of the substrate was then bombarded by argon ions for 60 minutes. Although not performed in this example, metal ion bombardment can also be employed with a metal target.

After nitrogen reaction gas within the range of 0.1 to 9.0 Pa as shown in Table 2 was introduced into the deposition system for a predetermined time, the furnace temperature was maintained as shown in Table 2 while a predetermined DC bias voltage within the range of -10 to -500 V as shown in Table 2 was applied to the revolving substrate on the turn table. A predetermined DC bias voltage within the range of -10 to -500 V (the same range for the first and second sublayers) and a predetermined current within the range of 80 to 240 A shown in Table 2 were applied to generate an arc discharge for fabrication of Inventive Coated Tools (hereinafter referred to as "Examples") 1 to 9 shown in Table 3.

For comparison, a coating layer was deposited on each of Substrates 1 to 3 in the same deposition system under the conditions shown in Table 2 to produce comparative example coating tools (hereinafter referred to as "Comparative Examples") 1 to 9 shown in Table 4.

The average thicknesses of the first and second sublayers of the coating layer and the average composition of the coating layer were determined by the method described above.

The B content at the cutting edge ridge of the coating layer was measured at five points (the distance between adjacent points was 0.5 mm) on a line segment of the cutting edge ridge of the coating layer by EPMA. Similarly, the B content in a region at least 1 mm away from the cutting edge ridge of the coating layer toward the flank surface was measured at five points on a line segment 1.5 mm away from and parallel to the cutting edge ridge of the coating layer toward the flank surface. Each B content was the average of the five points.

**[Table 1]**

| Substrate | Composition(mass%) | | | | | | |
|---|---|---|---|---|---|---|---|
| | Co | TiC | VC | TaC | NbC | Cr₃C₂ | WC |
| 1 | 9.0 | 0.0 | 1.5 | 0.0 | 1.5 | 0.0 | Balance |
| 2 | 11. 0 | 0.0 | 1.0 | 0.0 | 0.0 | 1.0 | Balance |
| 3 | 10. 0 | 0.8 | 0.0 | 0. 5 | 1.0 | 0.0 | Balance |

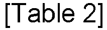

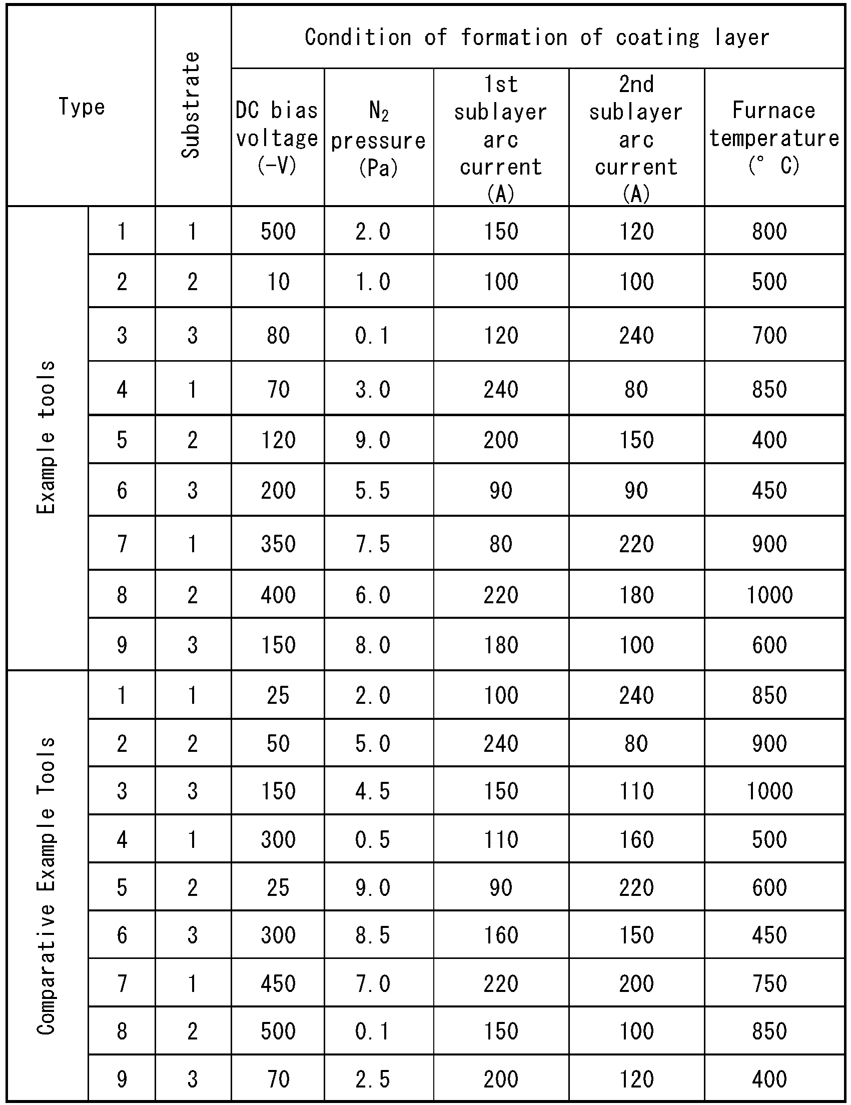

The furnace temperature, DC bias voltage and arc current shown in Table 2 were kept constant throughout the deposition period.

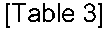

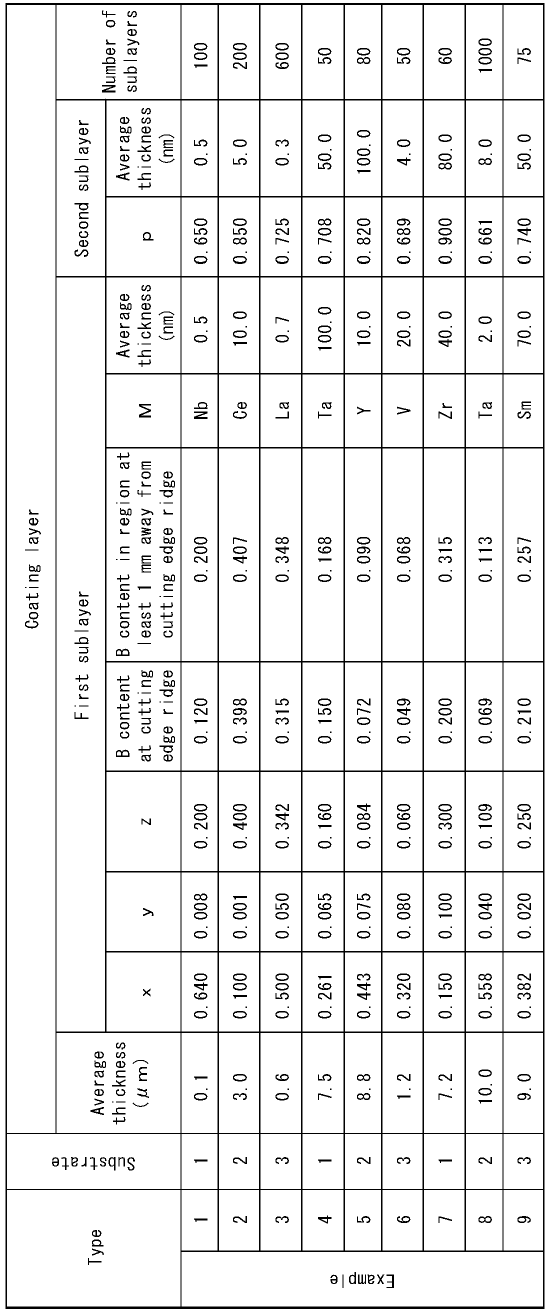

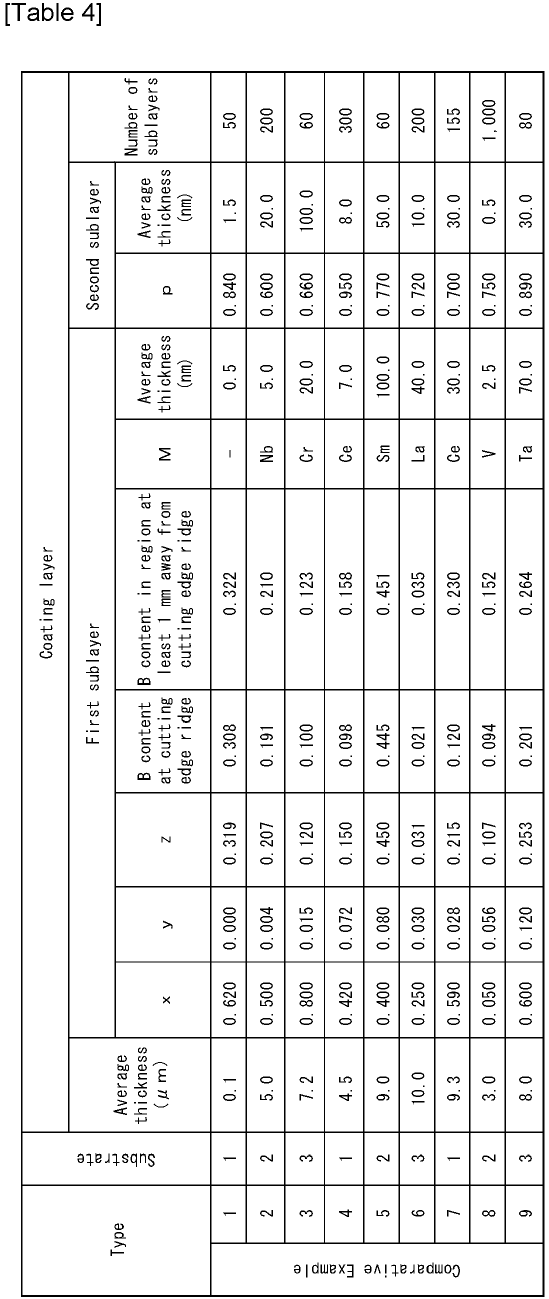

In Table 4, symbol "-" indicates not contained.

Tools 1 to 9 of the present invention and Tools 1 to 9 of the comparative examples were subjected to a single-edge face milling test with a SE445R0506E cutter. Cutting test A and cutting test B were performed as high-speed cutting tests for stainless steels such as martensitic stainless steel.

### Cutting test A:

Workpiece: block of 60 mm wide by 200 mm long
Cutting speed: 160 m/min.
Cutting depth: 1.5 mm
Feed: 0.12 mm/tooth.
Martensitic stainless steel SUS420J2 was served to wet high-speed cutting tests under such conditions. After the workpiece was cut up to a cutting length of 1.8 m, the flank wear width was measured and the worn state of the cutting edge was observed.

The results of cutting test A are shown in Table 5.

### Cutting test B:

Workpiece: block of 60 mm wide by 200 mm long
Cutting speed: 170 m/min.
Cutting depth: 1.5 mm
Feed: 0.10 mm/tooth.
Martensitic stainless steel SUS304 was served to wet high-speed cutting tests under such conditions. After the workpiece was cut up to a cutting length of 1.8 m, the flank wear width was measured and the worn state of the cutting edge was observed.

The results of cutting test B are shown in Table 6.

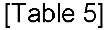

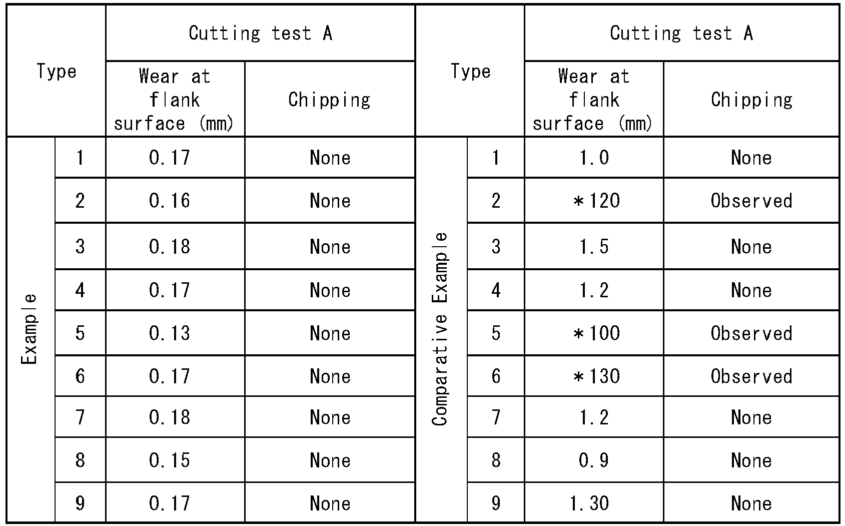

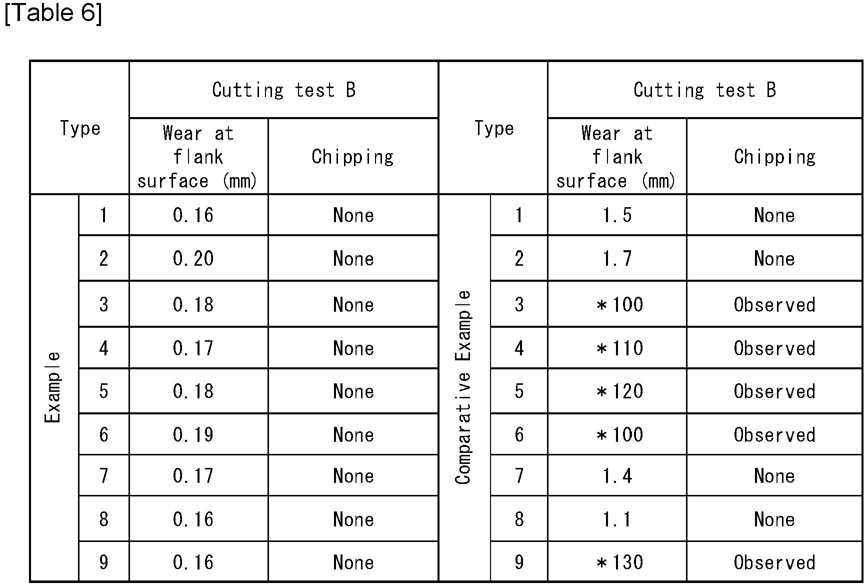

In Tables 5 and 6, symbol "*" indicates that the sample reached the tool life before the target cutting length (1.8 m), and numeral indicates the time (in seconds) until the life.

The results in Tables 5 and 6 demonstrates that Examples 1 to 9 do not experience abnormal damage such as chipping or delamination under either cutting conditions A or B and exhibit high wear resistance and chipping resistance.

In contrast, Comparative Examples 1 to 9 reaches the tool life within a short time due to the occurrence of chipping or propagation of wear on the flank surface under cutting conditions A and B.

The disclosed embodiments are in all respects illustrative only and are not restrictive; the scope of the invention is indicated by the claims, not the embodiments, and is intended to include all modifications within the meaning and scope of the claims and equivalents.

### Reference signs list

1 substrate
2 coating layer
3 first sublayer
4 second sublayer
5 rake surface
6 flank surface

## Claims

1. A surface coated cutting tool comprising a substrate and coating layer on the substrate; wherein
1) the coating layer has an average thickness in a range of 0.1 µm to 10.0 µm, the coating layer including first sublayers and second sublayers alternately deposited;
2) the first sublayers each has an average thickness in a range of 0.5 nm to 100.0 nm and has an average composition represented by the formula (AlₓTi_{1-x-y-z}M_{y})B_{z}N (where M is at least one element selected from the group consisting of groups 4, 5, and 6 elements and lanthanoid elements in the periodic table, x is in a range of 0.100 to 0.640, y is in a range of 0.001 to 0.100, and z is in a range of 0.060 to 0.400);
3) the second sublayers each has an average thickness in a range of 0.5 nm to 100.0 nm and has an average composition represented by the formula: (AlₚCr₁₋ₚ)N (where p is in a range of 0.650 to 0.900); and
4) the coating layer includes a cutting edge ridge and a flank and has a B content, the B content at the cutting edge being at least 60% of the B content in an area at least 1 mm away from the cutting edge ridge toward the flank.
